# EUROPEAN PATENT SPECIFICATION

(11) **EP 3 550 727 B1**
(45) Date of publication and mention of the grant of the patent: **22.09.2021**
(21) Application number: 18736703.2
(22) Date of filing: 04.01.2018
(51) Int. Cl.: H03M 13/17, H03M 13/00, H04B 7/06, H04L 1/18

(54) **DATA TRANSMISSION METHOD AND APPARATUS**
DATENÜBERTRAGUNGSVERFAHREN UND -VORRICHTUNG
PROCÉDÉ ET APPAREIL DE TRANSMISSION DE DONNÉES

(30) Priority: 06.01.2017 CN 201710010425
(43) Date of publication of application: 09.10.2019
(73) Proprietor: Huawei Technologies Co., Ltd., Longgang District Shenzhen, Guangdong 518129 (CN)
(72) Inventor: DU, Bai, Shenzhen Guangdong 518129 (CN); ZHANG, Peng, Shenzhen Guangdong 518129 (CN)
(74) Representative: Pfenning, Meinig & Partner mbB
(86) International application number: PCT/CN2018/071368
(87) International publication number: WO 2018/127094

(56) References cited:
- WO-A1-2016/148944
- CN-A- 102 394 685
- CN-A- 107 113 122
- MEDIATEK INC: "URLLC and eMBB DL Multiplexing using CRC", 3GPP DRAFT; R1-1612149_URLLC AND EMBB MULTIPLEXING USING CRC_FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRA , vol. RAN WG1, no. Reno, USA; 20161114 - 20161118 13 November 2016 (2016-11-13), XP051176101, Retrieved from the Internet: URL:http://www.3gpp.org/ftp/Meetings_3GPP_ SYNC/RAN1/Docs/ [retrieved on 2016-11-13]
- INTEL CORPORATION: "Downlink URLLC transmission and multiplexing with eMBB", 3GPP DRAFT; R1-1612003 INTEL - URLLC DL_MUX, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Reno, USA; 20161114 - 20161118 13 November 2016 (2016-11-13), XP051175967, Retrieved from the Internet: URL:http://www.3gpp.org/ftp/Meetings_3GPP_ SYNC/RAN1/Docs/ [retrieved on 2016-11-13]
- SONY: "Dynamic Resource Sharing for eMBB/URLLC in DL", 3GPP DRAFT; R1-1613047 - REL-14 NR - EMBB URLLC MUX V05, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Reno, USA; 20161114 - 20161118 13 November 2016 (2016-11-13), XP051176971, Retrieved from the Internet: URL:http://www.3gpp.org/ftp/Meetings_3GPP_ SYNC/RAN1/Docs/ [retrieved on 2016-11-13]
- ZTE ET AL.: 'Multiplexing of eMBB and URLLC' 3GPP TSG RAN WG1 MEETING#86 RL-166408, [Online] 13 August 2016, GOTHENBURG, SWEDEN, XP051142381 Retrieved from the Internet: <URL:http://www.3gpp.org/ftp/tsg_ran/WG1_RL 1/TSGR1_86/Docs/>
- SAMSUNG: 'Evaluation Results of eMBB with HARQ Retransmission for Multiplexing eMBB and URLLC' 3GPPTSG RAN WG1 MEETING #87 R1-1612536, [Online] 04 November 2016, RENO, USA, XP051189402 Retrieved from the Internet: <URL:http://www.3gpp.org/ftp/tsg_ran/WG1_RL 1/TSGR1_87/Docs/>
- SAMSUNG: 'Evaluation Results of eMBB with HARQ Retransmission in Case of Multiplexing eMBB and URLLC' 3GPPTSG RAN WG1 MEETING #86BIS R1-1609057, [Online] 01 October 2016, LISBON, PORTUGAL, XP051159253 Retrieved from the Internet: <URL:http://www.3gpp.org/ftp/tsg_ran/WG1_RL 1/TSGR1_86b/Docs/>

## Description

### TECHNICAL FIELD

The present invention relates to the field of communications technologies, and in particular, to a data transmission method and apparatus.

### BACKGROUND

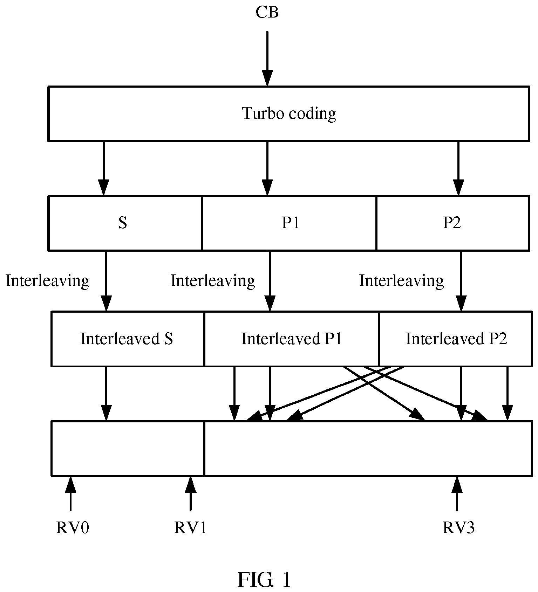

In a long term evolution (Long Term Evolution, LTE) system, to-be-transmitted information is segmented in a form of a transport block (Transmission Block, TB) based on an actual requirement, a cyclic redundancy check (Cyclic Redundancy Check, CRC) bit of each transport block is attached to the transport block, and one TB is sent at each transmission time interval (Transmission Time Interval, TTI). A transport block to which a CRC is attached is usually split into a plurality of code blocks (Code Block, CB) due to limitation of a coding length, and after CRC insertion, channel coding, and rate matching are performed on the CBs, referring to FIG. 1, an obtained data code stream is referred to as a codeword (codeword).

In the prior art, a TB transmitted by a transmit end is finally mapped to a codeword, and a receive end sends feedback information to the transmit end based on a decoding status of all data in the codeword. When some data in the codeword is punctured, feedback overheads of the receive end are relatively large and feedback efficiency is low.
MEDIATEK INC, "URLLC and eMBB DL Multiplexing using CRC", vol. RAN WG1, no. Reno, USA, 3GPP DRAFT, R1-1612149, describes that a mask is used on the CRC bits to indicate that a resource is punctured. An ACK is provided as feedback if all but the punctured resources are decoded correctly.
INTEL CORPORATION, "Downlink URLLC transmission and multiplexing with eMBB", vol. RAN WG1, no. Reno, 3GPP DRAFT, R1-1612003, describes pre- and post-indication of punctured resource elements in a dedicated channel. HARQ feedback is sent either for a complete transport block or codeblock-wise.
SONY, "Dynamic Resource Sharing for eMBB/URLLC in DL", vol. RAN WG1, no. Reno, USA, 3GPP DRAFT, R1-1613047, compares effects of post- and pre-indication of punctured resources and suggest retransmitting the punctured resources without waiting for a HARQ feedback to reduce latency.

### SUMMARY

The invention is set out in independent claims 1, 2, 3, 4, 5, 6, 7 and 8.

### BRIEF DESCRIPTION OF DRAWINGS

FIG. 1 is a schematic diagram of block interleaving and rate matching in the prior art;
FIG. 2 is a schematic diagram of a system architecture according to an embodiment of the present invention;
FIG. 3 shows an example of a schematic flowchart corresponding to a data transmission method according to Embodiment 1 of the present invention;
FIG. 4 is a schematic diagram of preempting eMBB data by URLLC data;
FIG. 5a is a schematic diagram of puncturing scheduling units according to Embodiment 1 of the present invention;
FIG. 5b is another schematic diagram of puncturing scheduling units according to Embodiment 1 of the present invention;
FIG. 5c is still another schematic diagram of puncturing scheduling units according to Embodiment 1 of the present invention;
FIG. 5d is yet another schematic diagram of puncturing scheduling units according to Embodiment 1 of the present invention;
FIG. 5e is still yet another schematic diagram of puncturing scheduling units according to Embodiment 1 of the present invention;
FIG. 6a is a schematic diagram of puncturing a slot 2 according to Embodiment 1 of the present invention;
FIG. 6b is a schematic diagram of a CB in a slot 2 according to Embodiment 1 of the present invention;
FIG. 6c is another schematic diagram of a CB in a slot 2 according to Embodiment 1 of the present invention;
FIG. 6d is still another schematic diagram of a CB in a slot 2 according to Embodiment 1 of the present invention;
FIG. 6e is a schematic diagram of puncturing a slot 1 and a slot 2 according to Embodiment 1 of the present invention;
FIG. 7 is a schematic diagram of puncturing statuses of CBs according to Example 2 of the present invention;
FIG. 8 is a schematic diagram of puncturing statuses of CB groups according to Example 3 of the present invention;
FIG. 9 is a schematic structural diagram of a data transmission apparatus according to Embodiment 6 of the present invention;
FIG. 10 is a schematic structural diagram of a data transmission apparatus according to Embodiment 7 of the present invention;
FIG. 11 is a schematic structural diagram of a communications apparatus according to Embodiment 8 of the present invention; and
FIG. 12 is a schematic structural diagram of a communications apparatus according to Embodiment 9 of the present invention.

### DESCRIPTION OF EMBODIMENTS

To make the objectives, technical solutions, and advantages of the present invention clearer, the following further describes the present invention in detail with reference to the accompanying drawings. Apparently, the described embodiments are merely some rather than all of the embodiments of the present invention.

In the specification, claims, and accompanying drawings of this application, the terms "first", "second", and the like are intended to distinguish between different objects but do not indicate a particular order. In addition, the terms "comprising", "including", or any other variant thereof, are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

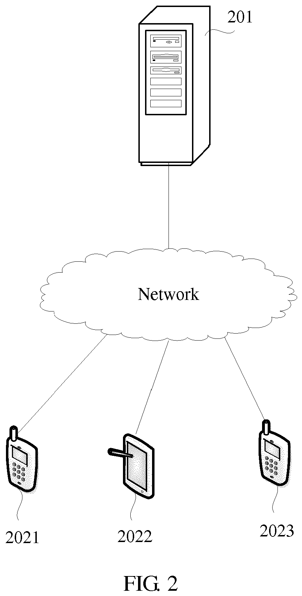

A data transmission method in an embodiment of the present invention may be applied to a plurality of system architectures. FIG. 2 is a schematic diagram of a system architecture to which an embodiment of the present invention is applicable. As shown in FIG. 2, the system architecture includes a network device 201 and one or more terminals, such as a first terminal 2021, a second terminal 2022, and a third terminal 2023 shown in FIG. 2. The network device 201 may transmit information with the first terminal 2021, the second terminal 2022, and the third terminal 2023 through a network. Further, the first terminal 2021, the second terminal 2022, and the third terminal 2023 may transmit information to each other.

In the embodiments of the present invention, the network device includes but is not limited to a NodeB NodeB, an evolved NodeB eNodeB, a base station in a fifth generation (the fifth generation, 5G) communications system, a base station in a future communications system, an access node in a Wi-Fi system, a wireless relay node, a wireless backhaul node, and user equipment (user equipment, UE). The base station is an apparatus deployed in a radio access network to provide a wireless communication function. For example, a device that provides a base station function in a 2G network includes a base transceiver station (base transceiver station, BTS) and a base station controller (base station controller, BSC). A device that provides a base station function in a 3G network includes a NodeB (NodeB) and a radio network controller (radio network controller, RNC). A device that provides a base station function in a 4G network includes an evolved NodeB (evolved NodeB, eNB). A device that provides a base station function in a 5G network includes a New Radio NodeB (New Radio NodeB, gNB), a centralized unit (Centralized Unit, CU), a distributed unit (Distributed Unit), and a New Radio controller. In a WLAN, a device that provides a base station function is an access point (Access Point, AP).

The terminal may be a device (device) providing voice and/or data connectivity for a user, and may include a wireless terminal and a wired terminal. The wireless terminal may be a handheld device having a wireless connection function, or another processing device connected to a wireless modem. The terminal communicates with one or more core networks through a radio access network (radio access network, RAN), or may access a distributed network in a self-organizing manner or a grant free manner, or may access a wireless network in another manner to perform communication. Alternatively, the terminal may directly perform wireless communication with another terminal, or the terminal may directly perform wireless communication with another terminal. For example, the terminal may be a mobile phone, a computer, a tablet computer, a personal digital assistant (Personal Digital Assistant, PDA), a mobile Internet device (Mobile Internet Device, MID), a wearable device, and an e-book reader (e-book reader). For another example, the wireless terminal may also be a portable, pocket-sized, handheld, computer built-in, or in-vehicle mobile device. For still another example, the wireless terminal may be a mobile station (Mobile Station), an access point (Access Point), or a part of UE.

A communications system to which the foregoing system architecture is applicable includes but is not limited to a code division multiple access (Code Division Multiple Access, CDMA) IS-95 system, a code division multiple access (Code Division Multiple Access, CDMA) 2000 system, a time division-synchronous code division multiple access (Time Division-Synchronous Code Division Multiple Access, TD-SCDMA) system, a wideband code division multiple access (Wideband Code Division Multiple Access, WCDMA) system, a time division duplexing-long term evolution (Time Division Duplexing-Long Term Evolution, TDD LTE) system, a frequency division duplexing-long term evolution (Frequency Division Duplexing-Long Term Evolution, FDD LTE) system, a long term evolution-advanced (Long Term Evolution-Advanced, LTE-advanced) system, and various future evolved wireless communications systems (such as a 5G system).

In an example of the 5G system (also known as the New Radio system), specifically, a new service type is defined in the 5G system: an ultra-reliable and low-latency communications (Ultra-Reliable and Low-Latency Communication, URLLC) service and an enhanced mobile broadband (Enhanced Mobile Broadband, eMBB) service. The URLLC service requires high reliability and a low latency, while the eMBB service primarily requires ensuring a peak rate. Therefore, the URLLC service tends to use scheduling time shorter than that of the eMBB service, and when the eMBB service is being transmitted, the URLLC service can directly replace some data sent by the eMBB service with data of the URLLC service for sending, resulting in an information transmission failure due to puncturing during information transmission.

For example, in a process in which the network device 201 sends, to the first terminal 2021, a TB used to transmit eMBB service data, if it is determined that the network device 201 needs to transmit URLLC service data to the first terminal 2021, the network device may puncture a plurality of CBs included in the TB, to be specific, replace some eMBB service data in the plurality of CBs with URLLC service data. In this way, after the first terminal 2021 receives the TB, the first terminal 2021 needs to feed back to the network device 201. If feedback is performed on all data according to the prior art, overheads are wasted and feedback efficiency is low.

Based on the foregoing system architecture, in an application scenario of the embodiments of the present invention, a first device is the network device 201, and a second device is any one of the first terminal 2021, the second terminal 2022, and the third terminal 2023. Alternatively, in another application scenario, a first device is any one of the first terminal 2021, the second terminal 2022, and the third terminal 2023, and a second device is the network device 201. Alternatively, in still another application scenario, a first device is any one of the first terminal 2021, the second terminal 2022, and the third terminal 2023, and a second device is a terminal, in the first terminal 2021, the second terminal 2022, and the third terminal 2023, other than the first device. In other words, the data transmission method in the embodiments of the present invention may be applied to uplink and downlink information transmission between a network device and a terminal, or may be applied to information transmission between different terminals. For downlink data transmission, the second device is a base station, and the corresponding first device is a terminal. For uplink data transmission, the second device is a terminal, and the corresponding first device is a base station. For D2D data transmission, the second device is UE, and the corresponding first device is also UE. This is not limited in the embodiments of this application.

A sending device and a receiving device in the embodiments of this application may be deployed on land and includes an indoor or outdoor device, a handheld device, or an in-vehicle device, or may be deployed on the water, or may be deployed on an airplane, a balloon, or a satellite in the air. The UE in the embodiments of this application may be a mobile phone, a tablet computer (Pad), a computer with a wireless transceiver function, a virtual reality (Virtual Reality, VR) terminal device, an augmented reality (Augmented Reality, AR) terminal device, a wireless terminal in industrial control (industrial control), a wireless terminal in self driving (self driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), or the like. An application scenario is not limited in the embodiments of this application.

### Embodiment 1

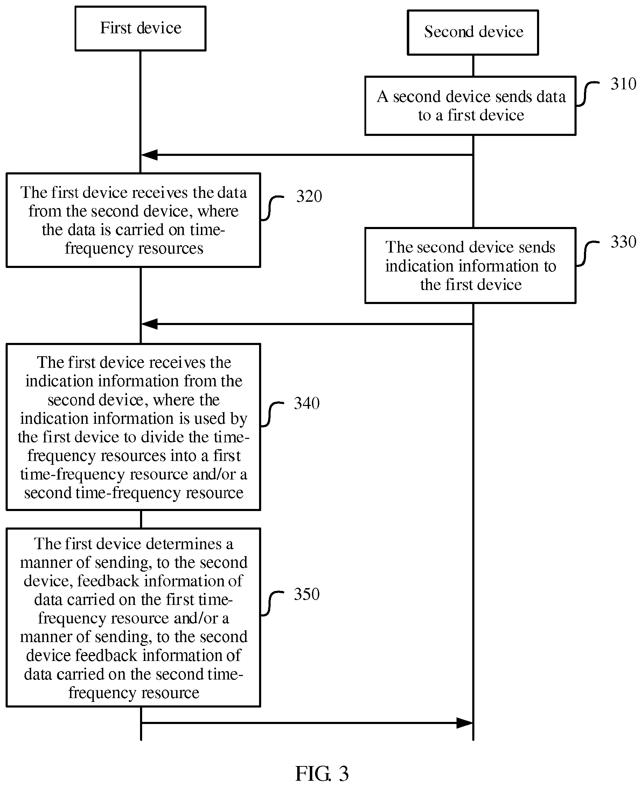

FIG. 3 shows an example of a schematic flowchart corresponding to a data transmission method according to Embodiment 1 of the present invention. As shown in FIG. 3, the method includes the following steps:
Step 310: A second device sends data to a first device, where the data is carried on time-frequency resources.
Step 320: The first device receives the data from the second device.
Step 330: The second device sends indication information to the first device.
Step 340: The first device receives the indication information from the first device, where the indication information is used by the first device to divide the time-frequency resources into a first time-frequency resource and/or a second time-frequency resource.
Step 350: The first device determines a manner of sending, to the second device, feedback information of data carried on the first time-frequency resource and/or a manner of sending, to the second device, feedback information of data carried on the second time-frequency resource.

It should be noted that sequence numbers of the steps are merely examples for describing an execution process. A specific sequence of the steps is not limited in this embodiment of the present invention, and some steps may be performed simultaneously or not performed according to the foregoing sequence numbers. For example, step 310 and step 330 may be simultaneously performed, or step 330 may be performed after step 310, and step 320 and step 340 may be simultaneously performed, or step 340 may be performed after step 320.

Specifically, in step 310, the second device sends, to the first device, data used to transmit a service, and the data is carried on time-frequency resources. If it is determined that other service data of a higher priority needs to be transmitted, the other service data of the higher priority may puncture the resources to which the data is mapped, to replace service data on some time-frequency resources with the other service data of the higher priority. After the replacement, data before the replacement is no longer sent on the resources on which data is replaced. The other service data of the higher priority may be from the second device or a device other than the first device and the second device. In addition, puncturing may also include a case in which a service sent by the device other than the first device and the second device causes strong interference to the first device, so that the second device stops sending the data of the service on a corresponding time-frequency resource.

Correspondingly, in step 320, the first device receives the data from the second device, and the data is specifically the service data of the higher priority that replaces service data on some time-frequency resources, and original service data that is still transmitted on other time-frequency resources.

In step 330, the second device sends the indication information to the first device.

Correspondingly, in step 340, the first device receives the indication information from the second device, where the indication information is used by the first device to divide the time-frequency resources into the first time-frequency resource and/or the second time-frequency resource.

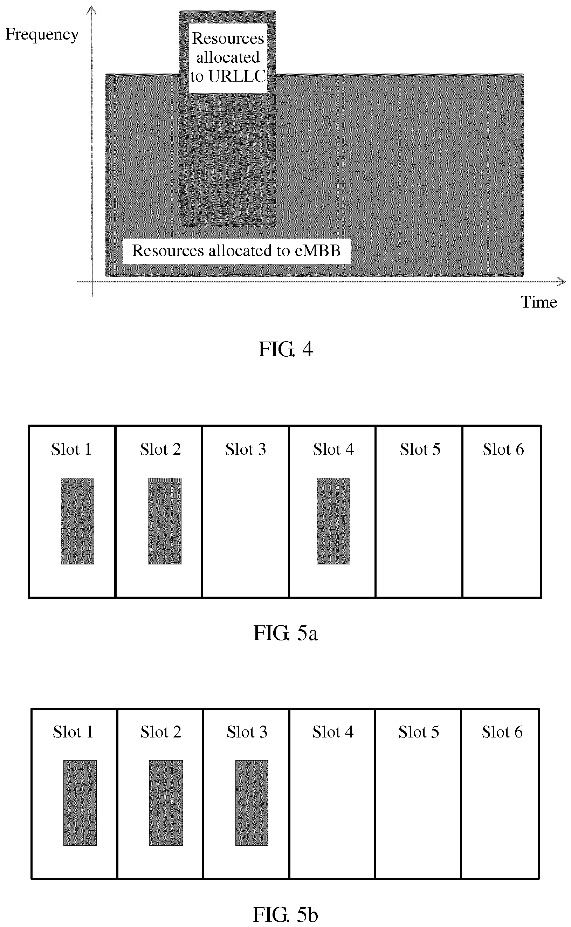

The indication information specifically includes at least one of scheduling unit identification information, CB identification information, and CB group identification information; or location information of a punctured area. When the indication information includes the location information of the punctured area, the first device calculates the first time-frequency resource based on the location information of the punctured area, and a time-frequency resource, in the time-frequency resources, other than the first time-frequency resource is the second time-frequency resource. The first device may determine the first time-frequency resource according to the following rule: When there is an intersection between at least one scheduling unit and the punctured area, the at least one scheduling unit belongs to the first time-frequency resource; or when there is an intersection between a time-frequency resource of at least one CB and the punctured area, the at least one CB belongs to the first time-frequency resource; or when there is an intersection between a time-frequency resource of at least one CB group and the punctured area, the at least one CB group belongs to the first time-frequency resource. The first device determines the first time-frequency resource (there may be a case in which all the time-frequency resources are the first time-frequency resource or all the time-frequency resources are the second time-frequency resource). All or some of service data on the first time-frequency resource is replaced with the service data of the higher priority. The second time-frequency resource is a time-frequency resource, in the time-frequency resources, other than the first time-frequency resource, and the original service data is still transmitted on the second time-frequency resource. The first device receives, from the second device, data that is carried on the first time-frequency resource and the second time-frequency resource. In this embodiment of the present invention, all or some of the service data on the first time-frequency resource may be replaced with the service data of the higher priority before the second device sends the data to the first device, or when the second device sends the data to the first device, or in a process in which the second device sends the data to the first device. The other service data of the higher priority may be from the second device or the device other than the first device and the second device. For example, the service sent by the device other than the first device and the second device causes strong interference to the first device, so that the second device stops sending the data of the service on the corresponding time-frequency resource. The service data with the higher priority may be service data that requires high reliability and a low latency, for example, URLLC service data in a 5G system that has a priority higher than that of eMBB service data. FIG. 4 is a schematic diagram of preempting eMBB data by URLLC data.

When the rule for determining the first time-frequency resource is that when there is an intersection between at least one scheduling unit and the punctured area, the at least one scheduling unit belongs to the first time-frequency resource, a scheduling unit may be a slot (slot) or a mini-slot (mini-slot). FIG. 5a includes six scheduling units, respectively a slot 1, a slot 2, a slot 3, a slot 4, a slot 5, and a slot 6. There is an intersection between the punctured area (shadow area) and each of the slot 1, the slot 2, and the slot 4. In this case, the slot 1, the slot 2, and the slot 4 are determined as the first time-frequency resource, and the remaining slot 3, slot 5, and slot 6 are determined as the second time-frequency resource.

The punctured area may alternatively be in a form shown in FIG. 5b. The punctured area is distributed in the slot 1, the slot 2, and the slot 3 in a discrete form. In this case, the slot 1, the slot 2, and the slot 3 are determined as the first time-frequency resource, and the remaining slot 4, slot 5, and slot 6 are determined as the second time-frequency resource.

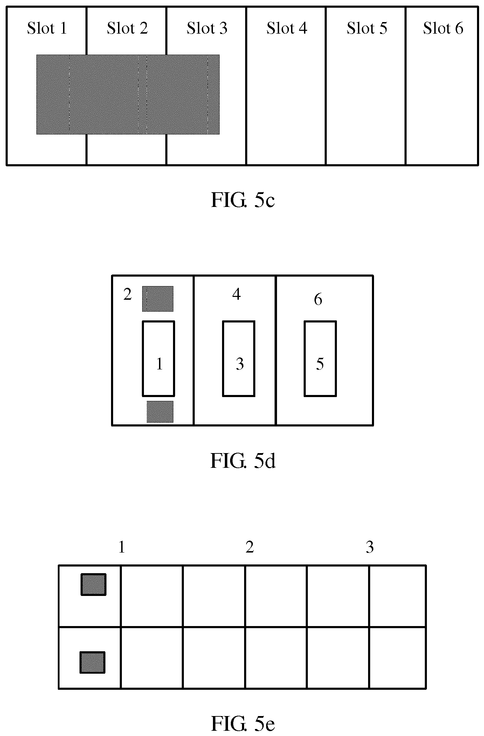

The punctured area may alternatively be in a form shown in FIG. 5c. The punctured area is distributed in the slot 1, the slot 2, and the slot 3 in a contiguous block form. In this case, the slot 1, the slot 2, and the slot 3 are determined as the first time-frequency resource, and the remaining slot 4, slot 5, and slot 6 are determined as the second time-frequency resource.

Scheduling units may be in a "hollow square" shape shown in FIG. 5d. A scheduling unit 1 is in a hollow of the "hollow square" shape, and a scheduling unit 2 is outside the hollow of the "hollow square" shape, and there is an intersection between the punctured area and the scheduling unit 2. In this case, the scheduling unit 2 is the first time-frequency resource, and the scheduling unit 1, a scheduling unit 3, a scheduling unit 4, a scheduling unit 5, and a scheduling unit 6 are the second time-frequency resource.

A scheduling unit may be in a "2x2 grid" shape shown in FIG. 5e. A scheduling unit includes a resource block 1, a resource block 2, a resource block 3, and a resource block 4 in a clockwise direction, and there is an intersection between the punctured area and each of the resource block 1 and the resource block 4. In this case, a scheduling unit 1 is the first time-frequency resource, and a scheduling unit 2 and a scheduling unit 3 are the second time-frequency resource.

In step 350, the first device determines a manner of sending, to the second device, the feedback information of the data carried on the first time-frequency resource and/or a manner of sending the feedback information of the data carried on the second time-frequency resource, and sends the feedback information to the second device in a determined manner of sending the feedback information. The feedback information may be determined based on a decoding status. For example, a CB carried on the second time-frequency resource is decoded, and if any CB is incorrectly decoded, for example, if a CRC check error occurs, a CB fails to be decoded, and a negative acknowledgement is fed back, such as a NACK, or otherwise, an acknowledgement is fed back, such as an ACK. In an existing LTE protocol, a TB is finally mapped to a codeword, and the feedback information is determined based on a data decoding status in the codeword. In this application, the first device feeds back only to some data in the codeword based on the indication information. Feedback information in the following Examples and Embodiments is the same as that herein, and details are not described below.

The first device determines three manners of sending the feedback information to the second device:
Manner 1: The first device determines not to send, to the second device, the feedback information of the data carried on the first time-frequency resource.
Manner 2: The first device determines to send, to the second device, feedback information of a first CB in the data carried on the first time-frequency resource, where the first device determines the first CB according to a preset rule, and the first CB is a part or all of the data on the first time-frequency resource.
Manner 3: The first device determines to send, to the second device, the feedback information of the data carried on the second time-frequency resource.

Therefore, the first device may send the feedback information to the second device in the following manners: the manner 1, the manner 2 (all time-frequency resources corresponding to the two manners are the first time-frequency resource), the manner 3 (all corresponding time-frequency resources are the second time-frequency resource), a manner 1+3, and a manner 2 + 3.

The following uses an example in which the indication information includes the scheduling unit identification information to describe in detail how the first device determines the first time-frequency resource based on the scheduling unit identification information, and processes feedback information in the manner 1+3 and the manner 2 + 3.

Specifically, when the indication information includes the scheduling unit identification information, the first device determines the first time-frequency resource based on the scheduling unit identification information. The identification information may be a scheduling unit number, or may be other information used to uniquely identify a scheduling unit.

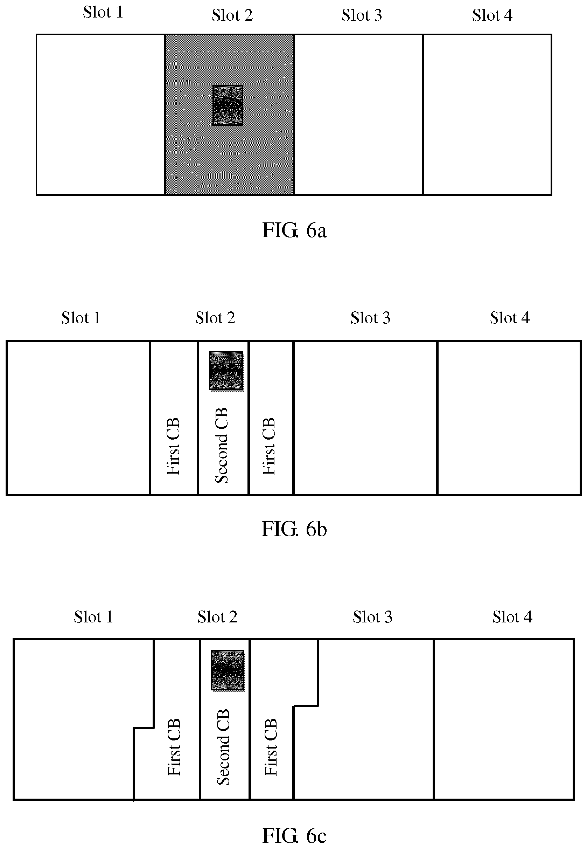

As shown in FIG. 6a, the second device receives the indication information from the first device, and the first device determines a slot 2 as the first time-frequency resource, and a slot 1, a slot 3, and a slot 4 as the second time-frequency resource according to the indication information.

In an implementation, both the first CB and a second CB are located in the slot 2, as shown in FIG. 6b. In this case, the first device sends feedback information of the slot 1, the slot 3, and the slot 4 to the second device, and does not send feedback information of the slot 2. The first device sends the feedback information of the slot 1, the slot 3, and the slot 4 to the second device in two manners.
Manner 1: The first device sends an acknowledgement, such as an ACK, to the second device if all CBs in the slot 1, the slot 3, and the slot 4 are correctly decoded, or the first device sends a negative acknowledgement, such as a NACK, to the second device if one CB in the slot 1, the slot 3, and the slot 4 is incorrectly decoded. The acknowledgement or the negative acknowledgement occupies 1 bit.
Manner 2: For CBs in the slot 1, the slot 3, and the slot 4, the first device sends an acknowledgement, such as an ACK, to the second device for a CB that is correctly decoded, or the first device sends a negative acknowledgement, such as a NACK, to the second device for a CB that is incorrectly decoded. A sum of quantities of acknowledgements and negative acknowledgements is equal to a sum of quantities of CBs in the slot 1, the slot 3, and the slot 4.

In another implementation, the first device determines the first CB according to the preset rule. For example, one part of the first CB is located in the slot 1 and the slot 3 and the other part is located in the slot 2, and a second CB is located in the slot 2, as shown in FIG. 6c. In this case, the first device may send a decoding status of a CB on the second time-frequency resource to the second device, and does not send a decoding status of the first CB. A specific manner of sending feedback information is the same as that in the foregoing implementation, and is not described herein again.

In addition, the first device may send decoding statuses of the first CB and the CB on the second time-frequency resource to the second device. The first device sends an acknowledgement, such as an ACK, to the second device if all the CB on the second time-frequency resource and the first CB are correctly decoded, or the first device sends a negative acknowledgement, such as a NACK, to the second device if at least one of the CB on the second time-frequency resource and the first CB is incorrectly decoded. Alternatively, the first device sends an acknowledgement, such as an ACK, to the second device if the first CB is correctly decoded; the first device sends a negative acknowledgement, such as a NACK, to the second device if the first CB is incorrectly decoded; the first device sends an acknowledgement, such as an ACK, to the second device if the CB on the second time-frequency resource is correctly decoded; or the first device sends a negative acknowledgement, such as a NACK, to the second device if the CB on the second time-frequency resource is incorrectly decoded. Alternatively, the first device sends an acknowledgement to the second device for a CB that is correctly decoded in the CB on the second time-frequency resource and the first CB, or the first device sends a negative acknowledgement to the second device for a CB that is incorrectly decoded in the CB on the second time-frequency resource and the first CB.

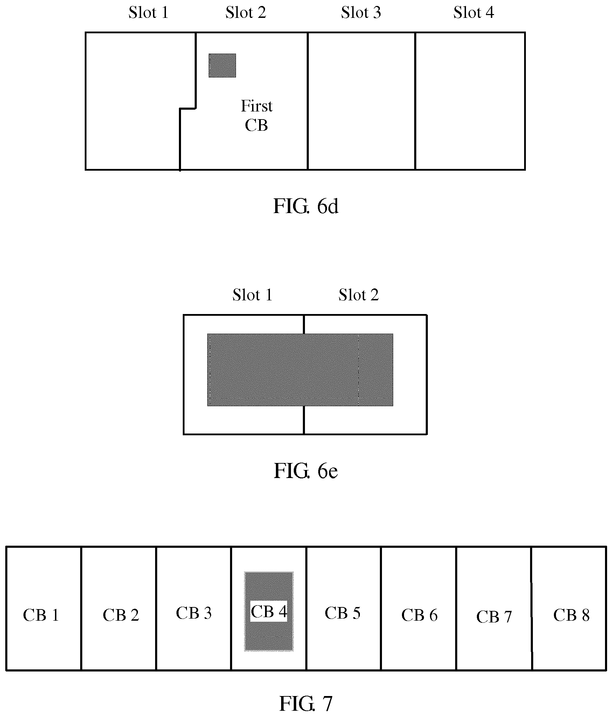

In still another implementation, there is only the first CB in the slot 2, one part of the first CB is located in the slot 2, and the other part is located in the slot 1, as shown in FIG. 6d. In this case, the first device may send the feedback information of the first time-frequency resource, to be specific, the slot 1, the slot 3, and the slot 4, to the second device, and does not send the feedback information of the second time-frequency resource, to be specific, the slot 2. In another case, the first device may send the feedback information of the first time-frequency resource and the second time-frequency resource, to be specific, the slot 1, the slot 2, the slot 3, and the slot 4, to the second device. A specific manner of sending the feedback information is the same as that in the foregoing implementation, and is not described herein again.

In yet another implementation, as shown in FIG. 6e, if the slot 1 and the slot 2 are punctured, both the slot 1 and the slot 2 are determined as the first time-frequency resource, and there is no second time-frequency resource. Therefore, the first device does not send the feedback information of the second time-frequency resource. In this case, the first device may send only the feedback information of the first time-frequency resource, to be specific, the slot1 and the slot2, to the second device, or the first device may send no feedback information.

In still yet another implementation, if there is only the second time-frequency resource but no first time-frequency resource, the first device sends only the feedback information of the second time-frequency resource to the second device.

### Example 2

In Embodiment 1, a first time-frequency resource is determined based on a scheduling unit, and corresponding processing is performed. Example 2, useful for understanding the invention, describes how a first device determines the first time-frequency resource based on a CB and correspondingly sends feedback information.

When the first device receives indication information from a second device, and the indication information includes CB identification information, and when there is an intersection between a time-frequency resource of at least one CB and a punctured area, the at least one CB belongs to the first time-frequency resource.

FIG. 7 is a schematic diagram of puncturing statuses of CBs. Specifically, puncturing statuses of a CB 1, a CB 2, a CB 3, a CB 4, a CB 5, a CB 6, a CB 7, and a CB 8 are shown. The first device determines the CB 4 as the first time-frequency resource, and the CB 1, the CB 2, the CB 3, the CB 5, the CB 6, the CB 7, and the CB 8 as a second time-frequency resource based on the CB identification information in the indication information.

That the first device sends, to the second device, feedback information of data carried on the second time-frequency resource specifically includes: sending, by the first device, a decoding status of a CB on the second time-frequency resource to the second device; and sending, by the first device, an acknowledgement to the second device if all the CB is correctly decoded, or sending, by the first device, a negative acknowledgement to the second device if at least one of the CB is incorrectly decoded; or sending, by the first device, an acknowledgement to the second device for a CB that is correctly decoded, or sending, by the first device, a negative acknowledgement to the second device for a CB that is incorrectly decoded.

In this example, because there are seven CBs on the second time-frequency resource, and an acknowledgement or a negative acknowledgement of each CB corresponds to one ACK or one NACK, feedback information of the seven CBs is n ACKs and (7-n) NACKs, and n is an integer less than 7.

In this example, there is also a case in which there is only the first time-frequency resource but no second time-frequency resource, or there is only the second time-frequency resource but no first time-frequency resource in the foregoing example. In this case, an implementation of the sending, by the first device, the feedback information to the second device is the same as a corresponding implementation in Embodiment 1, and details are not described herein again.

### Example 3

Corresponding processing is performed based on a plurality of CBs included in data in Example 2. In view of a case in which there may be a relatively large quantity of CBs, the present invention further provides Example 3, useful for understanding the present invention, in which CBs are specifically grouped to obtain a plurality of CB groups and processing is performed based on the CB groups, thereby effectively decreasing processing resources. Further, in Example 3, the CBs are grouped based on a relationship between slots in which a plurality of CBs are located. CBs that are adjacent in slots and use a same subcarrier are grouped into one CB group. In other words, any one of the plurality of CB groups includes at least one CB, and at least one CB included in any CB group intersects in frequency domain and is adjacent in time domain.

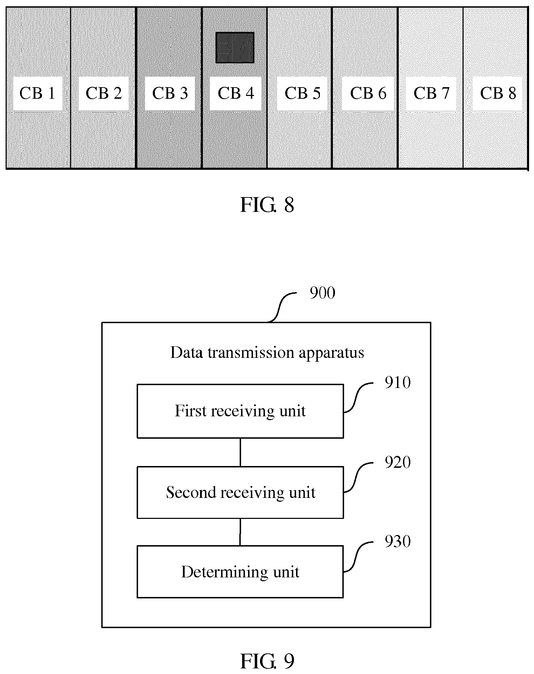

When a first device receives indication information from a second device, and the indication information includes CB group identification information, and when there is an intersection between a time-frequency resource of at least one CB group and a punctured area, the at least one CB group belongs to a first time-frequency resource. For example, referring to FIG. 8, a CB 1 and a CB 2 are in a CB group 1, a CB 3 and a CB 4 are in a CB group 2, a CB 5 and a CB 6 are in a CB group 3, and a CB 7 and a CB 8 are in a CB group 4. Based on the indication information from the second device, the CB 4 in the CB group 2 is partially punctured, and the first device determines that the first time-frequency resource is the CB group 2, and a second time-frequency resource is the CB group 1, the CB group 3, and the CB group 4.

That the first device sends, to the second device, feedback information of data carried on the second time-frequency resource specifically includes: sending, by the first device, a decoding status of a CB group on the second time-frequency resource to the second device; and sending, by the first device, an acknowledgement, such as one ACK, to the second device if all the CB group is correctly decoded, or sending, by the first device, a negative acknowledgement, such as one NACK, to the second device if at least one of the CB group is incorrectly decoded; or
sending, by the first device, a decoding status of a CB group on the second time-frequency resource to the second device; and sending, by the first device, an acknowledgement to the second device for a CB group that is correctly decoded, or sending, by the first device, a negative acknowledgement to the second device for a CB group that is incorrectly decoded. Feedback information of the three CB groups is m ACKs and (3-m) NACKs, and m is an integer less than 3.

In this example, there is also a case in which there is only the first time-frequency resource but no second time-frequency resource, or there is only the second time-frequency resource but no first time-frequency resource, or feedback information of some or all of the first time-frequency resource is sent, and feedback information of the second time-frequency resource is also sent in the foregoing example. In this case, an implementation of the sending, by the first device, the feedback information to the second device is the same as a corresponding implementation in Embodiment 1, and details are not described herein again.

### Embodiment 4

Embodiment 4 describes how a first device determines a first time-frequency resource based on scheduling unit identification information and CB identification information and performs corresponding processing.

When the first device receives indication information from a second device, and the indication information includes the scheduling unit identification information and the CB identification information, the first device first determines, based on the scheduling unit identification information, an overall range of time-frequency resources on which feedback information needs to be sent this time. For example, the indication information includes a slot 1, a slot 2, a slot 3, and a slot 4 (referring to FIG. 6a), and it indicates that feedback information of the four slots needs to be sent. The first device then determines location information of a punctured CB based on the CB identification information, to determine a slot in which a punctured area is located, for example, the slot 2 in which the punctured CB is located, and the first device determines the first time-frequency resource, namely, the slot 2. Finally, the first device does not send feedback information of the first time-frequency resource, and sends feedback information of a second time-frequency resource. A subsequent step of sending, by the first device, the feedback information of the second time-frequency resource to the second device is the same as the step in Embodiment 1, and is not described herein again.

### Example 5

Example 5, useful for understanding the invention, describes how a first device determines a first time-frequency resource based on location information of a punctured area and performs corresponding processing.

When the first device receives indication information from a second device, and the indication information includes the location information of the punctured area, the first device may determine the first time-frequency resource based on the location information of the punctured area. For example, a slot 2, a CB 4, or a CB group 2 is determined as the first time-frequency resource. A subsequent step of sending, by the first device, feedback information of a second time-frequency resource to the second device is the same as that in Embodiment 1, Example 2, or Example 3, and is not described herein again.

### Embodiment 6

For the foregoing method procedure, the embodiments of this application further provide a data transmission apparatus. For specific content of the data transmission apparatus, refer to the foregoing method implementations.

FIG. 9 is a schematic structural diagram of a data transmission apparatus according to Embodiment 6 of the present invention. The data transmission apparatus is configured to perform a method procedure performed by the first device. As shown in FIG. 9, the data transmission apparatus 900 includes:
a first receiving unit 910, configured to receive data from a second device, where the data is carried on time-frequency resources;
a second receiving unit 920, configured to receive indication information from the second device, where the indication information is used by the data transmission apparatus to divide the time-frequency resources into a first time-frequency resource and/or a second time-frequency resource; and
a determining unit 930, configured to determine a manner of sending, to the second device, feedback information of data carried on the first time-frequency resource and/or a manner of sending, to the second device, feedback information of data carried on the second time-frequency resource.

Specifically, the indication information includes at least one of scheduling unit identification information, code block CB identification information, and CB group identification information; or location information of a punctured area.

When the indication information is the location information of the punctured area, the data transmission apparatus calculates the first time-frequency resource based on the location information of the punctured area, and a time-frequency resource, in the time-frequency resources, other than the first time-frequency resource is the second time-frequency resource.

When there is an intersection between at least one scheduling unit and the punctured area, the at least one scheduling unit belongs to the first time-frequency resource; or
when there is an intersection between a time-frequency resource of at least one CB and the punctured area, the at least one CB belongs to the first time-frequency resource; or
when there is an intersection between a time-frequency resource of at least one CB group and the punctured area, the at least one CB group belongs to the first time-frequency resource.

Further, the apparatus further includes a sending unit, configured to skip sending, to the second device, the feedback information of the data carried on the first time-frequency resource.

The sending unit is configured to send, to the second device, feedback information of a first CB in the data carried on the first time-frequency resource, where the data transmission apparatus determines the first CB according to a preset rule, and the first CB is a part or all of the data on the first time-frequency resource.

The sending unit is configured to send, to the second device, the feedback information of the data carried on the second time-frequency resource.

Further, when not sending, to the second device, the feedback information of the data carried on the first time-frequency resource, and sending, to the second device, the feedback information of the data carried on the second time-frequency resource, the sending unit is specifically configured to: send a decoding status of a CB on the second time-frequency resource to the second device, and send an acknowledgement to the second device if all the CB is correctly decoded, or send a negative acknowledgement to the second device if at least one of the CB is incorrectly decoded; or
send an acknowledgement to the second device for a CB that is correctly decoded, or send a negative acknowledgement to the second device for a CB that is incorrectly decoded.

Further, when not sending, to the second device, the feedback information of the data carried on the first time-frequency resource, and sending, to the second device, the feedback information of the data carried on the second time-frequency resource, the sending unit is specifically configured to: send a decoding status of a CB group on the second time-frequency resource to the second device, and send an acknowledgement to the second device if all the CB group is correctly decoded, or send a negative acknowledgement to the second device if at least one of the CB group is incorrectly decoded; or
send an acknowledgement to the second device for a CB group that is correctly decoded, or send a negative acknowledgement to the second device for a CB group that is incorrectly decoded.

Further, when sending, to the second device, the feedback information of the first CB in the data carried on the first time-frequency resource, and sending, to the second device, the feedback information of the data carried on the second time-frequency resource, the sending unit is specifically configured to: send decoding statuses of a CB on the second time-frequency resource and the first CB to the second device, and send an acknowledgement to the second device if all the CB on the second time-frequency resource and the first CB are correctly decoded, or send a negative acknowledgement to the second device if at least one of the CB on the second time-frequency resource and the first CB is incorrectly decoded; or
send decoding statuses of a CB on the second time-frequency resource and the first CB to the second device, and send an acknowledgement to the second device if the first CB is correctly decoded, send a negative acknowledgement to the second device if the first CB is incorrectly decoded, send an acknowledgement to the second device if all the CB on the second time-frequency resource is correctly decoded, or send a negative acknowledgement to the second device if at least one of the CB on the second time-frequency resource is incorrectly decoded; or
send decoding statuses of a CB on the second time-frequency resource and the first CB to the second device, and send an acknowledgement to the second device for a CB that is correctly decoded in the CB on the second time-frequency resource and the first CB, or send a negative acknowledgement to the second device for a CB that is incorrectly decoded in the CB on the second time-frequency resource and the first CB.

### Embodiment 7

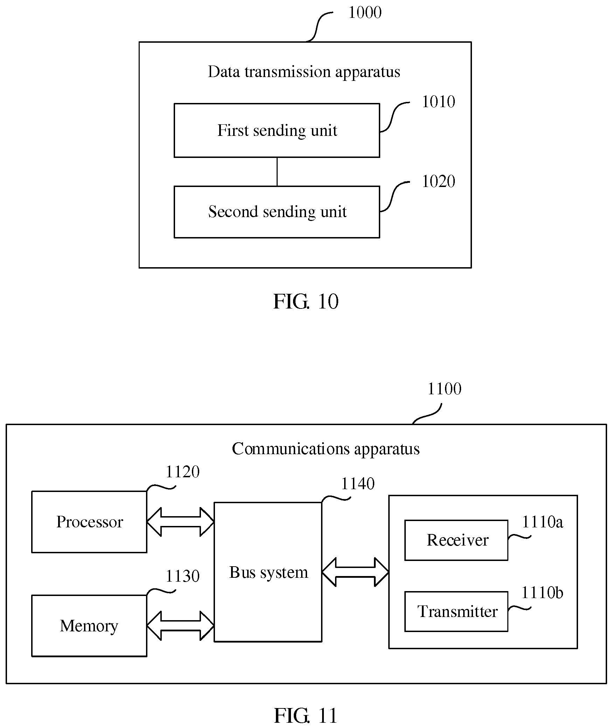

FIG. 10 is a schematic structural diagram of a data transmission apparatus according to Embodiment 7 of the present invention. The data transmission apparatus is configured to perform a method procedure performed by the second device. As shown in FIG. 10, the data transmission apparatus 1000 includes: a first sending unit 1010 and a second sending unit 1020.

The first sending unit 1010 is configured to send data to a first device, where the data is carried on time-frequency resources.

The second sending unit 1020 is configured to send indication information to the first device, where the indication information is used by the first device to divide the time-frequency resources into a first time-frequency resource and/or a second time-frequency resource, and to determine a manner of sending, to the data transmission apparatus, feedback information of data carried on the first time-frequency resource and/or a manner of sending, to the second device, feedback information of data carried on the second time-frequency resource.

The indication information includes at least one of scheduling unit identification information, code block CB identification information, and CB group identification information; or location information of a punctured area.

Specifically, when the indication information is the location information of the punctured area, the first device calculates the first time-frequency resource based on the location information of the punctured area, and a time-frequency resource, in the time-frequency resources, other than the first time-frequency resource is the second time-frequency resource.

When there is an intersection between at least one scheduling unit and the punctured area, the at least one scheduling unit belongs to the first time-frequency resource; or when there is an intersection between a time-frequency resource of at least one CB and the punctured area, the at least one CB belongs to the first time-frequency resource; or when there is an intersection between a time-frequency resource of at least one CB group and the punctured area, the at least one CB group belongs to the first time-frequency resource.

Further, the apparatus further includes a receiving unit, and the receiving unit is configured to skip receiving, from the first device, the feedback information of the data carried on the first time-frequency resource.

The receiving unit is configured to receive, from the first device, feedback information of a first CB in the data carried on the first time-frequency resource, where the first device determines the first CB according to a preset rule, and the first CB is a part or all of the data on the first time-frequency resource.

The receiving unit is configured to receive the feedback information of the data on the second time-frequency resource from the first device.

When not receiving, from the first device, the feedback information of the data carried on the first time-frequency resource, and receiving the feedback information of the data on the second time-frequency resource from the first device, the receiving unit is specifically configured to: receive a decoding status of a CB on the second time-frequency resource from the first device, where the receiving unit receives an acknowledgement from the first device if all the CB is correctly decoded, or the receiving unit receives a negative acknowledgement from the first device if at least one of the CB is incorrectly decoded; or
receive a decoding status of a CB on the second time-frequency resource from the first device, where the receiving unit receives an acknowledgement from the first device for a CB that is correctly decoded, or the receiving unit receives a negative acknowledgement from the first device for a CB that is incorrectly decoded.

When not receiving, from the first device, the feedback information of the data carried on the first time-frequency resource, and receiving the feedback information of the data on the second time-frequency resource from the first device, the receiving unit is specifically configured to: receive a decoding status of a CB group on the second time-frequency resource from the first device, and receive an acknowledgement from the first device if all the CB group is correctly decoded, or receive a negative acknowledgement from the first device if at least one of the CB group is incorrectly decoded;or
receive a decoding status of a CB group on the second time-frequency resource from the first device, and receive an acknowledgement from the first device for a CB group that is correctly decoded, or receive a negative acknowledgement from the first device for a CB group that is incorrectly decoded.

When the receiving unit receives, from the first device, the feedback information of the first CB in the data carried on the first time-frequency resource, and receives the feedback information of the data on the second time-frequency resource from the first device, the receiving unit is specifically configured to: receive decoding statuses of a CB on the second time-frequency resource and the first CB from the first device, and receive an acknowledgement from the first device if all the CB on the second time-frequency resource and the first CB are correctly decoded, or receive a negative acknowledgement from the first device if at least one of the CB on the second time-frequency resource and the first CB is incorrectly decoded; or
receive decoding statuses of a CB on the second time-frequency resource and the first CB from the first device, and receive an acknowledgement from the first device if the first CB is correctly decoded, receive a negative acknowledgement from the first device if the first CB is incorrectly decoded, receive an acknowledgement from the first device if all the CB on the second time-frequency resource is correctly decoded, or receive a negative acknowledgement from the first device if at least one of the CB on the second time-frequency resource is incorrectly decoded; or
receive decoding statuses of a CB on the second time-frequency resource and the first CB from the first device, and receive an acknowledgement from the first device for a CB that is correctly decoded in the CB on the second time-frequency resource and the first CB, or receive a negative acknowledgement from the first device for a CB that is incorrectly decoded in the CB on the second time-frequency resource and the first CB.

### Embodiment 8

FIG. 11 is a schematic structural diagram of a communications apparatus according to Embodiment 8 of the present invention. The communications apparatus may be a terminal or a base station, and is configured to perform a method procedure performed by the first device. As shown in FIG. 11, the device 1100 includes a receiver 1110a, a transmitter 1110b, a processor 1120, a memory 1130, and a bus system 1140.

The memory 1130 is configured to store a program. Only one memory is shown in FIG. 11. Certainly, a plurality of memories may be disposed as required. The memory 1130 may be a memory in the processor 1120.

The memory 1130 stores the following elements: an executable module or a data structure, a subset thereof, or an extended set thereof;
operation instructions, including various operation instructions and used to implement various operations; and
operating systems, including various system programs and configured to implement various basic services and process hardware-based tasks.

The processor 1120 controls an operation of the device 1100, and the processor 1120 may alternatively be referred to as a CPU (Central Processing Unit, central processing unit). In a specific application, all components of the device 1100 are coupled together by using the bus system 1140, and the bus system 1140 may further include a power supply bus, a control bus, a status signal bus, and the like in addition to a data bus. However, for clear description, various types of buses in the figure are marked as the bus system 1140. For ease of illustration, FIG. 11 shows merely an example of the bus system 1140.

The methods disclosed in the embodiments of this application may be applied to the processor 1120, or may be implemented by the processor 1120. The processor 1120 may be an integrated circuit chip and has a signal processing capability. In an implementation process, steps in the foregoing methods can be implemented by using a hardware integrated logical circuit in the processor 1120, or by using instructions in a form of software. The processor 1120 may be a general purpose processor, a digital signal processor (DSP), an application-specific integrated circuit (ASIC), a field programmable gate array (FPGA) or another programmable logic device, a discrete gate or a transistor logic device, or a discrete hardware component. The processor 1120 may implement or perform the methods, the steps, and logical block diagrams that are disclosed in the embodiments of this application. The general purpose processor may be a microprocessor, or the processor may be any conventional processor or the like. Steps of the methods disclosed with reference to the embodiments of this application may be directly executed and accomplished by a hardware decoding processor, or may be executed and accomplished by using a combination of hardware and software modules in the decoding processor. A software module may be located in a mature storage medium in the art, such as a random access memory, a flash memory, a read-only memory, a programmable read-only memory, an electrically erasable programmable memory, a register, or the like. The storage medium is located in the memory 1130. The processor 1120 reads information from the memory 1130, and performs the following steps in combination with hardware of the processor 1120.

The receiver 1110a is configured to receive data from a second device, where the data is carried on time-frequency resources.

The receiver 1110a is further configured to receive indication information from the second device, where the indication information is used by the data transmission apparatus to divide the time-frequency resources into a first time-frequency resource and/or a second time-frequency resource, and the processor 1120 is configured to determine a manner of sending, to the second device, feedback information of data carried on the first time-frequency resource and/or a manner of sending, to the second device, feedback information of data carried on the second time-frequency resource.

Further, the indication information includes at least one of scheduling unit identification information, code block CB identification information, and CB group identification information; or location information of a punctured area.

Further, when the indication information is the location information of the punctured area, the communications apparatus calculates the first time-frequency resource based on the location information of the punctured area, and a time-frequency resource, in the time-frequency resources, other than the first time-frequency resource is the second time-frequency resource.

Further, when there is an intersection between at least one scheduling unit and the punctured area, the at least one scheduling unit belongs to the first time-frequency resource; or when there is an intersection between a time-frequency resource of at least one CB and the punctured area, the at least one CB belongs to the first time-frequency resource; or when there is an intersection between a time-frequency resource of at least one CB group and the punctured area, the at least one CB group belongs to the first time-frequency resource.

Further, the transmitter 1110b is specifically configured to skip sending, to the second device, the feedback information of the data carried on the first time-frequency resource.

The transmitter 1110b is specifically configured to send, to the second device, feedback information of a first CB in the data carried on the first time-frequency resource, where the communications apparatus determines the first CB according to a preset rule, and the first CB is a part or all of the data on the first time-frequency resource.

The transmitter 1110b is specifically configured to send, to the second device, the feedback information of the data carried on the second time-frequency resource.

Further, when not sending, to the second device, the feedback information of the data carried on the first time-frequency resource, and sending, to the second device, the feedback information of the data carried on the second time-frequency resource, the transmitter 1110b is specifically configured to: send a decoding status of a CB on the second time-frequency resource to the second device, and send an acknowledgement to the second device if all the CB is correctly decoded, or send a negative acknowledgement to the second device if at least one of the CB is incorrectly decoded; or
send an acknowledgement to the second device for a CB that is correctly decoded, or send a negative acknowledgement to the second device for a CB that is incorrectly decoded.

Further, when not sending, to the second device, the feedback information of the data carried on the first time-frequency resource, and sending, to the second device, the feedback information of the data carried on the second time-frequency resource, the transmitter 1110b is specifically configured to: send a decoding status of a CB group on the second time-frequency resource to the second device, and send an acknowledgement to the second device if all the CB group is correctly decoded, or send a negative acknowledgement to the second device if at least one of the CB group is incorrectly decoded; or
send an acknowledgement to the second device for a CB group that is correctly decoded, or send a negative acknowledgement to the second device for a CB group that is incorrectly decoded.

Further, when sending, to the second device, the feedback information of the first CB in the data carried on the first time-frequency resource, and sending, to the second device, the feedback information of the data carried on the second time-frequency resource, the transmitter 1110b is specifically configured to: send decoding statuses of a CB on the second time-frequency resource and the first CB to the second device, and send an acknowledgement to the second device if all the CB on the second time-frequency resource and the first CB are correctly decoded, or send a negative acknowledgement to the second device if at least one of the CB on the second time-frequency resource and the first CB is incorrectly decoded; or
send an acknowledgement to the second device if the first CB is correctly decoded, send a negative acknowledgement to the second device if the first CB is incorrectly decoded, send an acknowledgement to the second device if all the CB on the second time-frequency resource is correctly decoded, or send a negative acknowledgement to the second device if at least one of the CB on the second time-frequency resource is incorrectly decoded; or
send an acknowledgement to the second device for a CB that is correctly decoded in the CB on the second time-frequency resource and the first CB, or send a negative acknowledgement to the second device for a CB that is incorrectly decoded in the CB on the second time-frequency resource and the first CB.

### Embodiment 9

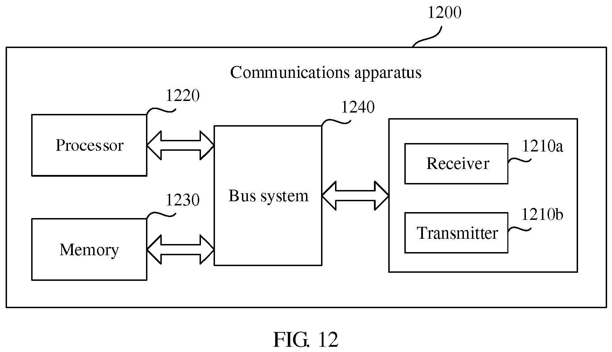

FIG. 12 is a schematic structural diagram of a communications apparatus according to Embodiment 9 of the present invention. The communications apparatus may be a terminal or a base station, and is configured to perform a method procedure performed by the second device. As shown in FIG. 12, the device 1200 includes a transmitter 1210a, a receiver 1210b, a processor 1220, a memory 1230, and a bus system 1240.

The memory 1230 is configured to store a program. Only one memory is shown in FIG. 12. Certainly, a plurality of memories may be disposed as required. The memory 1230 may be a memory in the processor 1220.

The memory 1230 stores the following elements: an executable module or a data structure, a subset thereof, or an extended set thereof;
operation instructions, including various operation instructions and used to implement various operations; and
operating systems, including various system programs and configured to implement various basic services and process hardware-based tasks.

The processor 1220 controls an operation of the terminal 1200, and the processor 1220 may alternatively be referred to as a CPU. In specific application, all components of the terminal 1200 are coupled together by using the bus system 1240, and the bus system 1240 may further include a power supply bus, a control bus, a status signal bus, and the like in addition to a data bus. However, for clear description, various types of buses in the figure are marked as the bus system 1240. For ease of illustration, FIG. 12 shows merely an example of the bus system 1240.

The methods disclosed in the embodiments of this application may be applied to the processor 1220, or may be implemented by the processor 1220. The processor 1220 may be an integrated circuit chip and has a signal processing capability. In an implementation process, steps in the foregoing methods can be implemented by using a hardware integrated logical circuit in the processor 1220, or by using instructions in a form of software. The processor 1220 may be a general purpose processor, a DSP, an ASIC, an FPGA or another programmable logic device, a discrete gate or transistor logic device, or a discrete hardware component. The processor 1220 may implement or perform the methods, the steps, and logical block diagrams that are disclosed in the embodiments of this application. The general purpose processor may be a microprocessor, or the processor may be any conventional processor or the like. Steps of the methods disclosed with reference to the embodiments of this application may be directly executed and accomplished by a hardware decoding processor, or may be executed and accomplished by using a combination of hardware and software modules in the decoding processor. A software module may be located in a mature storage medium in the art, such as a random access memory, a flash memory, a read-only memory, a programmable read-only memory, an electrically erasable programmable memory, a register, or the like. The storage medium is located in the memory 1230. The processor 1220 reads information from the memory 1230, and performs the following steps in combination with hardware of the processor 1120.

The transmitter 1210a is configured to send data to a first device, where the data is carried on time-frequency resources.

The transmitter 1210a is further configured to send indication information to the first device, where the indication information is used by the first device to divide the time-frequency resources into a first time-frequency resource and/or a second time-frequency resource, and to determine a manner of sending, to the data transmission apparatus, feedback information of data carried on the first time-frequency resource and/or a manner of sending, to the second device, feedback information of data carried on the second time-frequency resource.

Further, the indication information includes at least one of scheduling unit identification information, code block CB identification information, and CB group identification information; or location information of a punctured area.

When the indication information is the location information of the punctured area, the first device calculates the first time-frequency resource based on the location information of the punctured area, and a time-frequency resource, in the time-frequency resources, other than the first time-frequency resource is the second time-frequency resource.

When there is an intersection between at least one scheduling unit and the punctured area, the at least one scheduling unit belongs to the first time-frequency resource; or
when there is an intersection between a time-frequency resource of at least one CB and the punctured area, the at least one CB belongs to the first time-frequency resource; or
when there is an intersection between a time-frequency resource of at least one CB group and the punctured area, the at least one CB group belongs to the first time-frequency resource.

The receiver 1210b does not receive, from the first device, the feedback information of the data carried on the first time-frequency resource.

The receiver 1210b receives, from the first device, feedback information of a first CB in the data carried on the first time-frequency resource, where the first device determines the first CB according to a preset rule, and the first CB is a part or all of the data on the first time-frequency resource.

The receiver 1210b receives the feedback information of the data on the second time-frequency resource from the first device.

When not receiving, from the first device, the feedback information of the data carried on the first time-frequency resource, and receiving the feedback information of the data on the second time-frequency resource from the first device, the receiver 1210b is specifically configured to: receive a decoding status of a CB on the second time-frequency resource from the first device, and receive an acknowledgement from the first device if all the CB is correctly decoded, or receive a negative acknowledgement from the first device if at least one of the CB is incorrectly decoded; or
receive a decoding status of a CB on the second time-frequency resource from the first device, and receive an acknowledgement from the first device for a CB that is correctly decoded, or receive a negative acknowledgement from the first device for a CB that is incorrectly decoded.

When not receiving, from the first device, the feedback information of the data carried on the first time-frequency resource, and receiving the feedback information of the data on the second time-frequency resource from the first device, the receiver 1210b is specifically configured to: receive a decoding status of a CB group on the second time-frequency resource from the first device, and receive an acknowledgement from the first device if all the CB group is correctly decoded, or receive a negative acknowledgement from the first device if at least one of the CB group is incorrectly decoded; or
receive a decoding status of a CB group on the second time-frequency resource from the first device, and receive an acknowledgement from the first device for a CB group that is correctly decoded, or receive a negative acknowledgement from the first device for a CB group that is incorrectly decoded.

When receiving, from the first device, the feedback information of the first CB in the data carried on the first time-frequency resource, and receiving the feedback information of the data on the second time-frequency resource from the first device, the receiver 1210b is specifically configured to: receive decoding statuses of a CB on the second time-frequency resource and the first CB from the first device, and receive an acknowledgement from the first device if all the CB on the second time-frequency resource and the first CB are correctly decoded, or receive a negative acknowledgement from the first device if at least one of the CB on the second time-frequency resource and the first CB is incorrectly decoded; or
receive decoding statuses of a CB on the second time-frequency resource and the first CB from the first device, and receive an acknowledgement from the first device if the first CB is correctly decoded, receive a negative acknowledgement from the first device if the first CB is incorrectly decoded, receive an acknowledgement from the first device if all the CB on the second time-frequency resource is correctly decoded, or receive a negative acknowledgement from the first device if at least one of the CB on the second time-frequency resource is incorrectly decoded; or
receive decoding statuses of a CB on the second time-frequency resource and the first CB from the first device, and receive an acknowledgement from the first device for a CB that is correctly decoded in the CB on the second time-frequency resource and the first CB, or receive a negative acknowledgement from the first device for a CB that is incorrectly decoded in the CB on the second time-frequency resource and the first CB.

The method steps in the embodiments of this application may be implemented in a hardware form, or may be implemented by a processor by executing a software instruction. The software instruction may include a corresponding software module. The software module may be stored in a random access memory (Random Access Memory, RAM), a flash memory, a read-only memory (Read-Only Memory, ROM), a programmable read-only memory (Programmable ROM, PROM), an erasable programmable read-only memory (Erasable PROM, EPROM), an electrically erasable programmable read-only memory (Electrically EPROM, EEPROM), a register, a hard disk, a removable hard disk, a CD-ROM, or any other form of storage medium known in the art. For example, a storage medium is coupled to a processor, so that the processor can read information from the storage medium or write information into the storage medium. Certainly, the storage medium may be a component of the processor. The processor and the storage medium may be located in an ASIC. In addition, the ASIC may be located in a sending device or a receiving device. Certainly, the processor and the storage medium may exist in the sending device or the receiving device as discrete components.

All or some of the foregoing embodiments may be implemented by software, hardware, firmware, or any combination thereof. When software is used to implement the embodiments, the embodiments may be implemented all or partially in a form of a computer program product. The computer program product includes one or more computer instructions. When the computer program instructions are loaded and executed on the computer, the procedure or functions according to the embodiments of the present invention are all or partially generated. The computer may be a general-purpose computer, a dedicated computer, a computer network, or other programmable apparatuses. The computer instruction may be stored in a computer-readable storage medium, or transmitted by using the computer-readable storage medium. The computer instruction may be transmitted from one website, computer, server, or data center to another website, computer, server, or data center in a wired (for example, a coaxial cable, a fiber, or a digital subscriber line (DSL)) or wireless (for example, infrared, wireless, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, DVD), a semiconductor medium (for example, a solid state disk solid state disk (SSD)), or the like.

It may be understood that various numbers in the embodiments of this application are merely for differentiation for ease of description, but are not used to limit the scope of the embodiments of this application.

It should be understood that sequence numbers of the foregoing processes do not mean execution sequences in the embodiments of this application. The execution sequences of the processes should be determined according to functions and internal logic of the processes, and should not be construed as any limitation on the implementation processes of the embodiments of this application.

The foregoing descriptions are merely specific implementations of the embodiments of this application, but are not intended to limit this application. Any variation or replacement readily figured out by a person skilled in the art within the technical scope of the claims shall fall within the protection scope of this application.

## Claims

1. A data transmission method, wherein the method comprises:
receiving (320), by a first device, data from a second device, wherein the data is carried on time-frequency resources and the data comprises a transport block containing a plurality of code blocks, CBs;
receiving (340), by the first device, indication information from the second device, wherein the indication information is used by the first device to divide the time-frequency resources into a first time-frequency resource and a second time-frequency resource; and
determining (350), by the first device, a manner of sending, to the second device, feedback information of data carried on the first time-frequency resource and a manner of sending, to the second device, feedback information of data carried on the second time-frequency resource;
wherein the indication information comprises scheduling unit identification information of a punctured area and when there is an intersection between at least one scheduling unit and the punctured area, the at least one scheduling unit belongs to the first time-frequency resource, wherein a scheduling unit is a slot or a mini-slot;
wherein after the determining (350), by the first device, a manner of sending, to the second device, feedback information of data carried on the first time-frequency resource and
a manner of sending, to the second device, feedback information of data carried on the second time-frequency resource, the method further comprises:
sending, by the first device to the second device, feedback information of a first CB, wherein the first device determines the first CB according to a preset rule, and the first CB is a part of the data on the first time-frequency resource;
sending, by the first device to the second device, the feedback information of the data carried on the second time-frequency resource, wherein the data carried on the second time-frequency resource contains at least one CB,
wherein when the first device sends, to the second device, the feedback information of the first CB, and the first device sends, to the second device, the feedback information of the data carried on the second time-frequency resource, the first device sends an acknowledgement to the second device if the first CB is correctly decoded, the first device sends a negative acknowledgement to the second device if the first CB is incorrectly decoded, the first device sends an acknowledgement to the second device if all the CBs on the second time-frequency resource are correctly decoded, or the first device sends a negative acknowledgement to the second device if at least one of the CBs on the second time-frequency resource is incorrectly decoded.

2. A data transmission method, wherein the method comprises:
sending (310), by a second device, data to a first device, wherein the data is carried on time-frequency resources and the data comprises a transport block containing a plurality of code blocks, CBs; and
sending (330), by the second device, indication information to the first device, wherein the indication information is used by the first device to divide the time-frequency resources into a first time-frequency resource and a second time-frequency resource, and to determine a manner of sending, to the second device, feedback information of data carried on the first time-frequency resource and a manner of sending, to the second device, feedback information of data carried on the second time-frequency resource;
wherein the indication information comprises scheduling unit identification information of a punctured area and when there is an intersection between at least one scheduling unit and the punctured area, the at least one scheduling unit belongs to the first time-frequency resource, wherein a scheduling unit is a slot or a mini-slot;
wherein after the first device determines the manner of sending, to the second device, the feedback information of the data carried on the first time-frequency resource and the manner of sending the feedback information of the data carried on the second time-frequency resource, the method further comprises:
receiving, by the second device from the first device, feedback information of a first CB,
wherein the first device determines the first CB according to a preset rule, and the first CB is a part of the data on the first time-frequency resource;
wherein when the second device receives, from the first device, the feedback information of the first CB, and the second device receives the feedback information of the data on the second time-frequency resource from the first device, wherein the data carried on the second time-frequency resource contains at least one CB, the second device receives an acknowledgement from the first device if the first CB is correctly decoded, the second device receives a negative acknowledgement from the first device if the first CB is incorrectly decoded, the second device receives an acknowledgement from the first device if all the CBs on the second time-frequency resource are correctly decoded, or the second device receives a negative acknowledgement from the first device if at least one of the CBs, on the second time-frequency resource is incorrectly decoded.

3. A data transmission apparatus (900), wherein the apparatus comprises a first receiving unit (910), a second receiving unit (920), a determining unit (930), and a sending unit;
the first receiving unit (910) is configured to receive data from a second device, wherein the data is carried on time-frequency resources and the data comprises a transport block containing a plurality of code blocks, CBs;
the second receiving unit (920) is configured to receive indication information from the second device, wherein the indication information is used by the data transmission apparatus to divide the time-frequency resources into a first time-frequency resource and a second time-frequency resource; and
the determining unit (930) is configured to determine a manner of sending, to the second device, feedback information of data carried on the first time-frequency resource and a manner of sending, to the second device, feedback information of data carried on the second time-frequency resource;
wherein the indication information comprises a scheduling unit identification information of a punctured area and when there is an intersection between at least one scheduling unit and the punctured area, the at least one scheduling unit belongs to the first time-frequency resource, wherein a scheduling unit is a slot or a mini-slot;
wherein the sending unit is configured to send, to the second device, feedback information of a first CB
wherein the data transmission apparatus determines the first CB according to a preset rule, and the first CB is a part of the data on the first time-frequency resource;
wherein when sending, to the second device, the feedback information of the first CB and sending, to the second device, the feedback information of the data carried on the second time-frequency resource,
wherein the data carried on the second time-frequency resource contains at least one CB, the sending unit is specifically configured to:
send an acknowledgement to the second device if the first CB is correctly decoded, send a negative acknowledgement to the second device if the first CB is incorrectly decoded, send an acknowledgement to the second device if all the CBs on the second time-frequency resource are correctly decoded, or send a negative acknowledgement to the second device if at least one of the CBs on the second time-frequency resource is incorrectly decoded.

4. A data transmission apparatus (1000), wherein the apparatus comprises a first sending unit (1010), a second sending unit (1020), and a receiving unit;
the first sending unit (1010) is configured to send data to a first device, wherein the data is carried on time-frequency resources and the data comprises a transport block containing a plurality of code blocks, CBs; and
the second sending unit (1020) is configured to send indication information to the first device, wherein the indication information is used by the first device to divide the time-frequency resources into a first time-frequency resource and a second time-frequency resource, and to determine a manner of sending, to the data transmission apparatus, feedback information of data carried on the first time-frequency resource and a manner of sending, to the second device, feedback information of data carried on the second time-frequency resource;
wherein the indication information comprises scheduling unit identification information of a punctured area and when there is an intersection between at least one scheduling unit and the punctured area, the at least one scheduling unit belongs to the first time-frequency resource, wherein a scheduling unit is a slot or a mini-slot;
wherein the receiving unit is configured to:
receive, from the first device, feedback information of a first CB, wherein the first device determines the first CB according to a preset rule, and the first CB is a part of the data on the first time-frequency resource; and
wherein when the receiving unit receives, from the first device, the feedback information of the first CB, and receives the feedback information of the data carried on the second time-frequency resource from the first device, wherein the data carried on the same time-frequency resource contains at least one CB, the receiving unit is specifically configured to: receive an acknowledgement from the first device if the first CB is correctly decoded, receive a negative acknowledgement from the first device if the first CB is incorrectly receive an acknowledgement from the first device if all the CBs on the second time-frequency resource are correctly decoded, or receive a negative acknowledgement from the first device if at least one of the CBs on the second time-frequency resource is incorrectly decoded.

5. A computer-readable storage comprising instructions which, when the program is executed by a computer, cause the computer to carry out the method of claim 1.

6. A computer-readable storage medium comprising instructions which, when the program is executed by a computer, cause the computer to carry out the method of claim 2.

7. A computer program product comprising instructions which, when the program is executed by a computer, cause the computer to carry out the method of claim 1.

8. A computer program product comprising instructions which, when the program is executed by a computer, cause the computer to carry out the method of claim 2.

## Patentansprüche

1. Datenübertragungsverfahren, wobei das Verfahren Folgendes umfasst:
Empfangen (320), durch eine erste Vorrichtung, von Daten von einer zweiten Vorrichtung, wobei die Daten auf Zeit-Frequenz-Ressourcen geführt werden und die Daten einen Transportblock umfassen, der mehrere Codeblocks, CBs, enthält;
Empfangen (340), durch die erste Vorrichtung, von Angabeinformationen von der zweiten Vorrichtung, wobei die Angabeinformationen durch die erste Vorrichtung verwendet werden zum Teilen der Zeit-Frequenz-Ressourcen in eine erste Zeit-Frequenz-Ressource und eine zweite Zeit-Frequenz-Ressource; und
Bestimmen (350), durch die erste Vorrichtung, einer Art zum Senden, an die zweite Vorrichtung, von Rückmeldungsinformationen von auf der ersten Zeit-Frequenz-Ressource geführten Daten und einer Art zum Senden, an die zweite Vorrichtung, von Rückmeldungsinformationen von auf der zweiten Zeit-Frequenz-Ressource geführten Daten;
wobei die Angabeinformationen Ablaufplanungseinheitsidentifikationsinformationen eines punktierten Bereichs umfassen, und wenn eine Überschneidung zwischen mindestens einer Ablaufplanungseinheit und dem punktierten Bereich vorliegt, die mindestens eine Ablaufplanungseinheit zu der ersten Zeit-Frequenz-Ressource gehört, wobei eine Ablaufplanungseinheit ein Slot oder ein Mini-Slot ist;
wobei das Verfahren nach dem Bestimmen (350), durch die erste Vorrichtung, einer Art zum Senden, an die zweite Vorrichtung, von Rückmeldungsinformationen von auf der ersten Zeit-Frequenz-Ressource geführten Daten und einer Art zum Senden, an die zweite Vorrichtung, von Rückmeldungsinformationen von auf der zweiten Zeit-Frequenz-Ressource geführten Daten, ferner Folgendes umfasst:
Senden, durch die erste Vorrichtung an die zweite Vorrichtung, von Rückmeldungsinformationen eines ersten CB, wobei die erste Vorrichtung den ersten CB gemäß einer vorgegebenen Regel bestimmt und der erste CB ein Teil der Daten auf der ersten Zeit-Frequenz-Ressource ist;
Senden, durch die erste Vorrichtung an die zweite Vorrichtung, der Rückmeldungsinformationen der auf der zweiten Zeit-Frequenz-Ressource geführten Daten, wobei die auf der zweiten Zeit-Frequenz-Ressource geführten Daten mindestens einen CB enthalten,
wobei, wenn die erste Vorrichtung die Rückmeldungsinformationen des ersten CB an die zweite Vorrichtung sendet und die erste Vorrichtung die Rückmeldungsinformationen der auf der zweiten Zeit-Frequenz-Ressource geführten Daten an die zweite Vorrichtung sendet, die erste Vorrichtung eine Bestätigung an die zweite Vorrichtung sendet, wenn der erste CB korrekt decodiert wird, die erste Vorrichtung eine Negativbestätigung an die zweite Vorrichtung sendet, wenn der erste CB inkorrekt decodiert wird, die erste Vorrichtung eine Bestätigung an die zweite Vorrichtung sendet, wenn sämtliche CBs auf der zweiten Zeit-Frequenz-Ressource korrekt decodiert werden oder die erste Vorrichtung eine Negativbestätigung an die zweite Vorrichtung sendet, wenn mindestens einer der CBs auf der zweiten Zeit-Frequenz-Ressource inkorrekt decodiert wird.

2. Datenübertragungsverfahren, wobei das Verfahren Folgendes umfasst:
Senden (310), durch eine zweite Vorrichtung, von Daten an eine erste Vorrichtung, wobei die Daten auf Zeit-Frequenz-Ressourcen geführt werden und die Daten einen Transportblock umfassen, der mehrere Codeblocks, CBs, enthält;
Senden (330), durch die zweite Vorrichtung, von Angabeinformationen an die erste Vorrichtung, wobei die Angabeinformationen durch die erste Vorrichtung verwendet werden zum Teilen der Zeit-Frequenz-Ressourcen in eine erste Zeit-Frequenz-Ressource und eine zweite Zeit-Frequenz-Ressource und zum Bestimmen einer Art zum Senden, an die zweite Vorrichtung, von Rückmeldungsinformationen von auf der ersten Zeit-Frequenz-Ressource geführten Daten und einer Art zum Senden, an die zweite Vorrichtung, von Rückmeldungsinformationen von auf der zweiten Zeit-Frequenz-Ressource geführten Daten;
wobei die Angabeinformationen Ablaufplanungseinheitsidentifikationsinformationen eines punktierten Bereichs umfassen, und wenn eine Überschneidung zwischen mindestens einer Ablaufplanungseinheit und dem punktierten Bereich vorliegt, die mindestens eine Ablaufplanungseinheit zu der ersten Zeit-Frequenz-Ressource gehört, wobei eine Ablaufplanungseinheit ein Slot oder ein Mini-Slot ist;
wobei das Verfahren, nachdem die erste Vorrichtung die Art zum Senden, an die zweite Vorrichtung, der Rückmeldungsinformationen der auf der ersten Zeit-Frequenz-Ressource geführten Daten und die Art zum Senden der Rückmeldungsinformationen der auf der zweiten Zeit-Frequenz-Ressource geführten Daten bestimmt, ferner Folgendes umfasst:
Empfangen, durch die zweite Vorrichtung von der ersten Vorrichtung, von Rückmeldungsinformationen eines ersten CB, wobei die erste Vorrichtung den ersten CB gemäß einer vorgegebenen Regel bestimmt und der erste CB ein Teil der Daten auf der ersten Zeit-Frequenz-Ressource ist;
wobei wenn die zweite Vorrichtung die Rückmeldungsinformationen des ersten CB von der ersten Vorrichtung empfängt und die zweite Vorrichtung die Rückmeldungsinformationen der auf der zweiten Zeit-Frequenz-Ressource geführten Daten von der ersten Vorrichtung empfängt, wobei die auf der zweiten Zeit-Frequenz-Ressource geführten Daten mindestens einen CB enthalten, die zweite Vorrichtung eine Bestätigung von der ersten Vorrichtung empfängt, wenn der erste CB korrekt decodiert wird, die zweite Vorrichtung eine Negativbestätigung von der ersten Vorrichtung empfängt, wenn der erste CB inkorrekt decodiert wird, die zweite Vorrichtung eine Bestätigung von der ersten Vorrichtung empfängt, wenn sämtliche CBs auf der zweiten Zeit-Frequenz-Ressource korrekt decodiert werden oder die zweite Vorrichtung eine Negativbestätigung von der ersten Vorrichtung empfängt, wenn mindestens einer der CBs auf der zweiten Zeit-Frequenz-Ressource inkorrekt decodiert wird.

3. Datenübertragungseinrichtung (900), wobei die Einrichtung eine erste Empfangseinheit (910), eine zweite Empfangseinheit (920), eine Bestimmungseinheit (930) und eine Sendeeinheit umfasst;
die erste Empfangseinheit (910) ausgelegt ist zum Empfangen von Daten von einer zweiten Vorrichtung, wobei die Daten auf Zeit-Frequenz-Ressourcen geführt werden und die Daten einen Transportblock umfassen, der mehrere Codeblocks, CBs, enthält;
die zweite Empfangseinheit (920) ausgelegt ist zum Empfangen von Angabeinformationen von der zweiten Vorrichtung, wobei die Angabeinformationen durch die Datenübertragungseinrichtung verwendet werden zum Teilen der Zeit-Frequenz-Ressourcen in eine erste Zeit-Frequenz-Ressource und eine zweite Zeit-Frequenz-Ressource; und
die Bestimmungseinheit (930) ausgelegt ist zum Bestimmen einer Art zum Senden, an die zweite Vorrichtung, von Rückmeldungsinformationen von auf der ersten Zeit-Frequenz-Ressource geführten Daten und einer Art zum Senden, an die zweite Vorrichtung, von Rückmeldungsinformationen von auf der zweiten Zeit-Frequenz-Ressource geführten Daten;
wobei die Angabeinformationen Ablaufplanungseinheitsidentifikationsinformationen eines punktierten Bereichs umfassen, und wenn eine Überschneidung zwischen mindestens einer Ablaufplanungseinheit und dem punktierten Bereich vorliegt, die mindestens eine Ablaufplanungseinheit zu der ersten Zeit-Frequenz-Ressource gehört, wobei eine Ablaufplanungseinheit ein Slot oder ein Mini-Slot ist;
wobei die Sendeeinheit ausgelegt ist zum Senden, an die zweite Vorrichtung, von Rückmeldungsinformationen eines ersten CB, wobei die Datenübertragungseinrichtung den ersten CB gemäß einer vorgegebenen Regel bestimmt und der erste CB ein Teil der Daten auf der ersten Zeit-Frequenz-Ressource ist;
wobei die Sendeeinheit beim Senden, an die zweite Vorrichtung, der Rückmeldungsinformationen des ersten CB und Senden, an die zweite Vorrichtung, der Rückmeldungsinformationen der auf der zweiten Zeit-Frequenz-Ressource geführten Daten, wobei die auf der zweiten Zeit-Frequenz-Ressource geführten Daten mindestens einen CB enthalten, insbesondere zu Folgendem ausgelegt ist:
Senden einer Bestätigung an die zweite Vorrichtung, wenn der erste CB korrekt decodiert wird, Senden einer Negativbestätigung an die zweite Vorrichtung, wenn der erste CB inkorrekt decodiert wird, Senden einer Bestätigung an die zweite Vorrichtung, wenn sämtliche CBs auf der zweiten Zeit-Frequenz-Ressource korrekt decodiert werden oder Senden einer Negativbestätigung an die zweite Vorrichtung, wenn mindestens einer der CBs auf der zweiten Zeit-Frequenz-Ressource inkorrekt decodiert wird.

4. Datenübertragungseinrichtung (1000), wobei die Einrichtung eine erste Sendeeinheit (1010), eine zweite Sendeeinheit (1020) und eine Empfangseinheit umfasst;
die erste Sendeeinheit (1010) ausgelegt ist zum Senden von Daten an eine erste Vorrichtung, wobei die Daten auf Zeit-Frequenz-Ressourcen geführt werden und die Daten einen Transportblock umfassen, der mehrere Codeblocks, CBs, enthält; und
die zweite Sendeeinheit (1020) ausgelegt ist zum Senden von Angabeinformationen an die erste Vorrichtung, wobei die Angabeinformationen durch die erste Vorrichtung verwendet werden zum Teilen der Zeit-Frequenz-Ressourcen in eine erste Zeit-Frequenz-Ressource und eine zweite Zeit-Frequenz-Ressource und zum Bestimmen einer Art zum Senden, an die Datenübertragungseinrichtung, von Rückmeldungsinformationen von auf der ersten Zeit-Frequenz-Ressource geführten Daten und einer Art zum Senden, an die zweite Vorrichtung, von Rückmeldungsinformationen von auf der zweiten Zeit-Frequenz-Ressource geführten Daten;
wobei die Angabeinformationen Ablaufplanungseinheitsidentifikationsinformationen eines punktierten Bereichs umfassen, und wenn eine Überschneidung zwischen mindestens einer Ablaufplanungseinheit und dem punktierten Bereich vorliegt, die mindestens eine Ablaufplanungseinheit zu der ersten Zeit-Frequenz-Ressource gehört, wobei eine Ablaufplanungseinheit ein Slot oder ein Mini-Slot ist;
wobei die Empfangseinheit zu Folgendem ausgelegt ist:
Empfangen, von der ersten Vorrichtung, von Rückmeldungsinformationen eines ersten CB, wobei die erste Vorrichtung den ersten CB gemäß einer vorgegebenen Regel bestimmt und der erste CB ein Teil der Daten auf der ersten Zeit-Frequenz-Ressource ist; und
wobei wenn die Empfangseinheit die Rückmeldungsinformationen des ersten CB von der ersten Vorrichtung empfängt und die Rückmeldungsinformationen der auf der zweiten Zeit-Frequenz-Ressource geführten Daten von der ersten Vorrichtung empfängt, wobei die auf der gleichen Zeit-Frequenz-Ressource geführten Daten mindestens einen CB enthalten, die Empfangseinheit insbesondere zu Folgendem ausgelegt ist:
Empfangen einer Bestätigung von der ersten Vorrichtung, wenn der erste CB korrekt decodiert wird, Empfangen einer Negativbestätigung von der ersten Vorrichtung, wenn der erste CB inkorrekt decodiert wird, Empfangen einer Bestätigung von der ersten Vorrichtung, wenn sämtliche CBs auf der zweiten Zeit-Frequenz-Ressource korrekt decodiert werden oder Empfangen einer Negativbestätigung von der ersten Vorrichtung, wenn mindestens einer der CBs auf der zweiten Zeit-Frequenz-Ressource inkorrekt decodiert wird.

5. Computerlesbarer Speicher, der Anweisungen umfasst, die bei Ausführung des Programms durch einen Computer bewirken, dass der Computer das Verfahren nach Anspruch 1 ausführt.

6. Computerlesbares Speichermedium, das Anweisungen umfasst, die bei Ausführung des Programms durch einen Computer bewirken, dass der Computer das Verfahren nach Anspruch 2 ausführt.

7. Computerprogrammprodukt, das Anweisungen umfasst, die bei Ausführung des Programms durch einen Computer bewirken, dass der Computer das Verfahren nach Anspruch 1 ausführt.

8. Computerprogrammprodukt, das Anweisungen umfasst, die bei Ausführung des Programms durch einen Computer bewirken, dass der Computer das Verfahren nach Anspruch 2 ausführt.

## Revendications

1. Procédé de transmission de données, le procédé comprenant les étapes consistant à :
recevoir (320), par un premier dispositif, des données en provenance d'un second dispositif, les données étant transportées sur des ressources temps-fréquence et les données comprenant un bloc de transport contenant une pluralité de blocs de codes (CB) ;
recevoir (340), par le premier dispositif, une information d'indication en provenance du second dispositif, l'information d'indication étant utilisée par le premier dispositif pour diviser les ressources temps-fréquence en une première ressource temps-fréquence et en une seconde ressource temps-fréquence ; et
déterminer (350), par le premier dispositif, un mode d'envoi, au second dispositif, d'une information de retour de données transportées sur la première ressource temps-fréquence et un mode d'envoi, au second dispositif, d'une information de retour de données transportées sur la seconde ressource temps-fréquence ;
l'information d'indication comprenant une information d'identification d'unité de planification d'une zone ponctionnée et, quand une intersection existe entre au moins une unité de planification et la zone ponctionnée, l'au moins une unité de planification appartenant à la première ressource temps-fréquence, une unité de planification étant un intervalle ou un mini-intervalle ;
après la détermination (350), par le premier dispositif, d'un mode d'envoi, au second dispositif, d'une information de retour de données transportées sur la première ressource temps-fréquence et d'un mode d'envoi, au second dispositif, d'une information de retour de données transportées sur la seconde ressource temps-fréquence, le procédé comprenant en outre les étapes consistant à :
envoyer, par le premier dispositif au second dispositif, une information de retour d'un premier CB, le premier dispositif déterminant le premier CB selon une règle prédéfinie et le premier CB étant une partie des données sur la première ressource temps-fréquence ;
envoyer, par le premier dispositif au second dispositif, l'information de retour des données transportées sur la seconde ressource temps-fréquence, les données transportées sur la seconde ressource temps-fréquence contenant au moins un CB,
où quand le premier dispositif envoie, au second dispositif, l'information de retour du premier CB et que le premier dispositif envoie, au second dispositif, l'information de retour des données transportées sur la seconde ressource temps-fréquence, le premier dispositif envoie un acquittement au second dispositif si le premier CB est décodé correctement, le premier dispositif envoie un acquittement négatif au second dispositif si le premier CB est décodé incorrectement, le premier dispositif envoie un acquittement au second dispositif si tous les CB sur la seconde ressource temps-fréquence sont décodés correctement ou le premier dispositif envoie un acquittement négatif au second dispositif si au moins un des CB sur la seconde ressource temps-fréquence est décodé incorrectement.

2. Procédé de transmission de données, le procédé comprenant les étapes consistant à :
envoyer (310), par un second dispositif, des données à un premier dispositif, les données étant transportées sur des ressources temps-fréquence et les données comprenant un bloc de transport contenant une pluralité de blocs de codes (CB) ; et
envoyer (330), par le second dispositif, une information d'indication au premier dispositif, l'information d'indication étant utilisée par le premier dispositif pour diviser les ressources temps-fréquence en une première ressource temps-fréquence et en une seconde ressource temps-fréquence et pour déterminer un mode d'envoi, au second dispositif, d'une information de retour de données transportées sur la première ressource temps-fréquence et un mode d'envoi, au second dispositif, d'une information de retour de données transportées sur la seconde ressource temps-fréquence ;
l'information d'indication comprenant une information d'identification d'unité de planification d'une zone ponctionnée et, quand une intersection existe entre au moins une unité de planification et la zone ponctionnée, l'au moins une unité de planification appartenant à la première ressource temps-fréquence, une unité de planification étant un intervalle ou un mini-intervalle ;
le procédé comprenant en outre, après la détermination, par le premier dispositif, du mode d'envoi, au second dispositif, de l'information de retour des données transportées sur la première ressource temps-fréquence et du mode d'envoi de l'information de retour des données transportées sur la seconde ressource temps-fréquence, l'étape consistant à :
recevoir, par le second dispositif en provenance du premier dispositif, une information de retour d'un premier CB, le premier dispositif déterminant le premier CB selon une règle prédéfinie et le premier CB étant une partie des données sur la première ressource temps-fréquence ;
où quand le second dispositif reçoit, en provenance du premier dispositif, l'information de retour du premier CB et que le second dispositif reçoit, en provenance du premier dispositif, l'information de retour des données sur la seconde ressource temps-fréquence, les données transportées sur la seconde ressource temps-fréquence contenant au moins un CB, le second dispositif reçoit un acquittement en provenance du premier dispositif si le premier CB est décodé correctement, le second dispositif reçoit un acquittement négatif en provenance du premier dispositif si le premier CB est décodé incorrectement, le second dispositif reçoit un acquittement en provenance du premier dispositif si tous les CB sur la seconde ressource temps-fréquence sont décodés correctement ou le second dispositif reçoit un acquittement négatif en provenance du premier dispositif si au moins un des CB sur la seconde ressource temps-fréquence est décodé incorrectement.

3. Appareil de transmission de données (900), l'appareil comprenant une première unité de réception (910), une seconde unité de réception (920), une unité de détermination (930) et une unité d'envoi ;
la première unité de réception (910) étant configurée pour recevoir des données en provenance d'un second dispositif, les données étant transportées sur des ressources temps-fréquence et les données comprenant un bloc de transport contenant une pluralité de blocs de codes (CB) ;
la seconde unité de réception (920) étant configurée pour recevoir une information d'indication en provenance du second dispositif, l'information d'indication étant utilisée par l'appareil de transmission de données pour diviser les ressources temps-fréquence en une première ressource temps-fréquence et en une seconde ressource temps-fréquence ; et
l'unité de détermination (930) étant configurée pour déterminer un mode d'envoi, au second dispositif, d'une information de retour de données transportées sur la première ressource temps-fréquence et un mode d'envoi, au second dispositif, d'une information de retour de données transportées sur la seconde ressource temps-fréquence ;
l'information d'indication comprenant une information d'identification d'unité de planification d'une zone ponctionnée et, quand une intersection existe entre au moins une unité de planification et la zone ponctionnée, l'au moins une unité de planification appartenant à la première ressource temps-fréquence, une unité de planification étant un intervalle ou un mini-intervalle ;
l'unité d'envoi étant configurée pour envoyer, au second dispositif, une information de retour d'un premier CB, l'appareil de transmission de données déterminant le premier CB selon une règle prédéfinie et le premier CB étant une partie des données sur la première ressource temps-fréquence ;
quand elle envoie, au second dispositif, l'information de retour du premier CB et quand elle envoie, au second dispositif, l'information de retour des données transportées sur la seconde ressource temps-fréquence, les données transportées sur la seconde ressource temps-fréquence contenant au moins un CB, l'unité d'envoi étant spécifiquement configurée pour :
envoyer un acquittement au second dispositif si le premier CB est décodé correctement, envoyer un acquittement négatif au second dispositif si le premier CB est décodé incorrectement, envoyer un acquittement au second dispositif si tous les CB sur la seconde ressource temps-fréquence sont décodés correctement ou envoyer un acquittement négatif au second dispositif si au moins un des CB sur la seconde ressource temps-fréquence est décodé incorrectement.

4. Appareil de transmission de données (1000), l'appareil comprenant une première unité d'envoi (1010), une seconde unité d'envoi (1020) et une unité de réception ;
la première unité d'envoi (1010) étant configurée pour envoyer des données à un premier dispositif, les données étant transportées sur des ressources temps-fréquence et les données comprenant un bloc de transport contenant une pluralité de blocs de codes (CB) ; et
la seconde unité d'envoi (1020) étant configurée pour envoyer une information d'indication au premier dispositif, l'information d'indication étant utilisée par le premier dispositif pour diviser les ressources temps-fréquence en une première ressource temps-fréquence et en une seconde ressource temps-fréquence et pour déterminer un mode d'envoi, à l'appareil de transmission de données, d'une information de retour de données transportées sur la première ressource temps-fréquence et un mode d'envoi, au second dispositif, d'une information de retour de données transportées sur la seconde ressource temps-fréquence ;
l'information d'indication comprenant une information d'identification d'unité de planification d'une zone ponctionnée et, quand une intersection existe entre au moins une unité de planification et la zone ponctionnée, l'au moins une unité de planification appartenant à la première ressource temps-fréquence, une unité de planification étant un intervalle ou un mini-intervalle ;
l'unité de réception étant configurée pour :
recevoir, en provenance du premier dispositif, une information de retour d'un premier CB, le premier dispositif déterminant le premier CB selon une règle prédéfinie et le premier CB étant une partie des données sur la première ressource temps-fréquence ; et
quand l'unité de réception reçoit, en provenance du premier dispositif, l'information de retour du premier CB et reçoit, en provenance du premier dispositif, l'information de retour des données transportées sur la seconde ressource temps-fréquence, les données transportées sur la même ressource temps-fréquence contenant au moins un CB, l'unité de réception étant spécifiquement configurée pour :
recevoir un acquittement en provenance du premier dispositif si le premier CB est décodé correctement, recevoir un acquittement négatif en provenance du premier dispositif si le premier CB est décodé incorrectement, recevoir un acquittement en provenance du premier dispositif si tous les CB sur la seconde ressource temps-fréquence sont décodés correctement ou recevoir un acquittement négatif en provenance du premier dispositif si au moins un des CB sur la seconde ressource temps-fréquence est décodé incorrectement.

5. Stockage lisible par ordinateur, comprenant des instructions qui, lorsque le programme est exécuté par un ordinateur, amènent l'ordinateur à réaliser le procédé selon la revendication 1.

6. Support de stockage lisible par ordinateur, comprenant des instructions qui, lorsque le programme est exécuté par un ordinateur, amènent l'ordinateur à réaliser le procédé selon la revendication 2.

7. Produit de programme informatique, comprenant des instructions qui, lorsque le programme est exécuté par un ordinateur, amènent l'ordinateur à réaliser le procédé selon la revendication 1.

8. Produit de programme informatique, comprenant des instructions qui, lorsque le programme est exécuté par un ordinateur, amènent l'ordinateur à réaliser le procédé selon la revendication 2.
